Europäisches Patentamt

European Patent Office

Office européen des brevets

(11) Veröffentlichungsnummer: **0 509 272 A1**

## (12) EUROPÄISCHE PATENTANMELDUNG

(21) Anmeldenummer: **92105024.1**

(22) Anmeldetag: **24.03.92**

(51) Int. Cl.5: **H03F 3/08**, H03F 1/48

(30) Priorität: **17.04.91 DE 4112557**

(43) Veröffentlichungstag der Anmeldung:
**21.10.92 Patentblatt 92/43**

(84) Benannte Vertragsstaaten:
**AT BE CH DE DK ES FR GB IT LI NL SE**

(71) Anmelder: **Standard Elektrik Lorenz Aktiengesellschaft**
**Lorenzstrasse 10**
**W-7000 Stuttgart 40(DE)**

(72) Erfinder: **Benz, Paul**
**Schwärmerweg 7**
**W-7000 Stuttgart 40(DE)**
Erfinder: **Steigenberger, Ulrich**
**Im Langen Hau 14**
**W-7000 Stuttgart 80(DE)**

(74) Vertreter: **Kugler, Hermann, Dipl.-Phys. et al**
**Standard Elektrik Lorenz AG Patent- und**
**Lizenzwesen Postfach 30 09 29**
**W-7000 Stuttgart 30(DE)**

(54) **Schaltungsanordnung zur Verstärkung eines elektrischen Signals.**

(57) Die Erfindung bezieht sich auf eine Schaltungsanordnung zur Verstärkung eines Signals in der optischen Übertragungstechnik. Zur Verbesserung des Übertragungsverhaltens des Verstärkers für das Ausgangssignal einer Photodiode, insbesondere einer PIN-Diode, ist der als Stromverstärker ausgebildete Transistorverstärker mit einer Strom-Strom-Gegenkopplung über ein Gegenkopplungsnetzwerk mit kapazitiven Spannungsteilern versehen. Durch eine geeignete Dimensionierung des aus einem Übertragungsspannungsteiler (C1,R1,C2,R2) und einem Schleifenspannungsteiler (C,C1,R1) gebildeten kapazitiven Spannungsteilers wird auch für hohe Frequenzen eine ausreichende Verstärkung bei genügendem Signal-Rausch-Abstand gewährleistet.

FIG.2

Die Erfindung betrifft eine Schaltungsanordnung zur Verstärkung eines elektrischen Signals, insbesondere des Photostroms einer Photodiode, welcher abhängig von der Intensität des auf die Photodiode einfallenden Lichts erzeugt wird.

Bei einer bekannten Schaltungsanordnung dieser Art (D. Lutzke, "Lichtwellenleitertechnik", R. Pflaum Verlag, München 1986, Seiten 282-285) ist ein Transimpedanzverstärker vorgesehen, der als Gegenkopplungsnetzwerk einen Rückkopplungswiderstand aufweist. Mit dieser Schaltungsanordnung ist ein Übertragungsverhalten realisierbar, mit dem aus der hochohmigen Stromquelle (Photodiode) eine niederohmige Spannungsquelle für die weitere Verstärkung gebildet wird. Die Bandbreite dieser Schaltung ist jedoch durch den Einfluß des Rückkopplungswiderstands begrenzt.

Bei einer weiteren Schaltungsanordnung ( H.-D. Kirschbaum, "Transistorverstärker 2, Teil 1", Teubner Studienskripten, Stuttgart 1985, Seiten 199-202) ist ein als Stromverstärker geschalteter Transistorverstärker mit einer Strom-Strom-Gegenkopplung aus einem Widerstandsnetzwerk versehen. Die hier beschriebene Schaltung enthält zwei Transistorstufen mit einem geteilten Emitterwiderstand am zweiten Transistor und mit einem vom Mittenanschluß dieses Emitterwiderstandes auf den Eingang, bzw. auf die Basis des ersten Transistors zurückgeführten Gegenkopplungswiderstand. Diese bekannte Schaltung ist zur Verstärkung besonders kleiner Eingangsströme, wie sie beispielsweise von Photodioden bei der Detektion von Lichtsignalen erzeugt werden, geeignet. Hier kommt es insbesondere darauf an für die weitere Auswertung des Stromes der Photodiode einen ausreichenden Signal-Rausch-Abstand auch bei der notwendigen Verstärkung des Stromes zu gewährleisten damit die Fehlerrate bei der anschließenden Informationsverarbeitung so gering wie möglich gehalten werden kann. Die Zusammenhänge zwischen der Fehlerrate und dem Signal-Rausch-Abstand sind beispielsweise in dem Buch G. Grau "Optische Nachrichtentechnik", Springer Verlag Berlin Heidelberg New York, auf der Seite 264 beschrieben. Außerdem muß berücksichtigt werden, daß die Verstärkung auch bei hohen Frequenzen ausreichend sein sollte, da die zu übertragende Bandbreite in der optischen Nachrichtentechnik sehr groß ist.

Auch diese bekannte Schaltungsanordnung hat den Nachteil, daß bei der Verstärkung des Photostromes einer Photodiode, insbesondere einer PIN-Diode, das Übertragungsverhalten bei hohen Frequenzen nicht optimal ist.

Der Erfindung liegt die Aufgabe zugrunde, eine Schaltungsanordnung zur Verstärkung eines elektrischen Signals mit den Merkmalen bes Oberbegriffs des Hauptanspruchs derart auszubilden, daß das Übertragungsverhalten bei der Verstärkung des Photostromes einer Photodiode verbessert ist.

Diese Aufgabe wird erfindungsgemäß mit den kennzeichnenden Merkmalen des Hauptanspruchs gelöst.

Vorteilhaft ist die erfindungsgemäße Schaltungsanordnung vor allem wegen der schaltungstechnisch einfach auszuführenden Verwendung eines aus zwei kapazitiven Spannungsteilern gebildeten Gegenkopplungsnetzwerks, das die sonstigen Eigenschaften des Stromverstärkerprinzip nicht beeinträchtigt und trotzdem eine erhebliche Verbesserung der Übertragungseigenschaften der Schaltungsanordnung bei hohen Frequenzen mit einem ausreichenden Signal-Rausch-Abstand des zu verarbeitenden Signals gewährleistet .

Eine Ausführungsform der erfindungsgemäßen Schaltungsanordnung mit den Merkmalen des Anspruchs 2 ermöglicht in vorteilhafter Weise eine optimale Schleifenverstärkung durch eine geeignete Bemessung der Widerstände und Kondensatoren der kapazitiven Spannungsteiler, wobei besonders der niederohmige Schaltungspunkt am Source-Anschluß der zweiten Transistorstufe ausgenutzt wird, der es gestattet den im Gegenkopplungszweig des Spannungsteilers liegenden Widerstand hochohmig zu wählen um einen günstigen Signal-Rausch-Abstand zu erhalten. Dieser hohe Widerstandswert ist möglich, da durch den relativ niederohmigen Schaltungspunkt an der Mittenanzapfung des kapazitiven Spannungsteilers dieser kapazitiv belastbar ist und somit ein relativ kleiner Kondensator im Gegenkopplungszweig einsetzbar ist. Hierbei kann jedoch immer gewährleistet werden, daß die Zeitkonstanten der beiden Teile des kapazitiven Spannungsteilers gleich sind und ein Teilerverhältnis von beispielsweise 1:10 realisiert werden kann. Mit dieser Ausführungsform wird somit auch für hohe Frequenzen ein hervorragendes Übertragungsverhalten gewährleistet.

Beim Ausführungsbeispiel der erfindungsgemäßen Schaltungsanordnung nach Anspruch 3 mit zwei Feldeffekttransistoren werden die Vorteile besonders deutlich, die aus der Kombination einer PIN-Diode mit einer Stromverstärkerschaltung resultieren. Die Verwendung einer PIN-Diode ist insbesondere gegenüber den üblicherweise verwendeten Avalanche-Photodioden vorteilhaft, da diese zwar eine sehr hohe Empfindlichkeit aufweisen, jedoch sehr teuer sind und außerdem eine Hochspannung zur Spannungsversorgung dieser Photodiode notwendig ist. Es wird somit eine wesentliche Vereinfachung und Verbilligung der Schaltungsanordnung erreicht.

Andere vorteilhafte Ausgestaltungen der Erfindung sind in den weiteren Unteranprüchen enthalten.

Ein Ausführungsbeispiel der Erfindung wird nachfolgend anhand der Figuren 1 bis 4 beschrieben und erläutert. Es zeigen:

Figur 1      ein Blockschaltbild eines Stromverstärkers mit Strom-Strom-Gegenkopplung,

Figur 2      eine prinzipielle, schaltungsmäßige Ausführung eines Stromverstärkers mit einer PIN-Photodiode am Eingang,

Figur 3      eine Prinzipschaltung eines Schleifenspannungsteilers,

Figur 4      eine Prinzipschaltung eines Übertragungsspannungsteilers,

Figur 5      ein Beispiel einer Ausgangsbeschaltung des Stromverstärkers nach Figur 2 mit einer angeschalteten Gate-Drain-Stufe,

Figur 6      ein weiteres Beispiel einer Ausgangsbeschaltung des Stromverstärkers mit einem Transimpedanzverstärker.

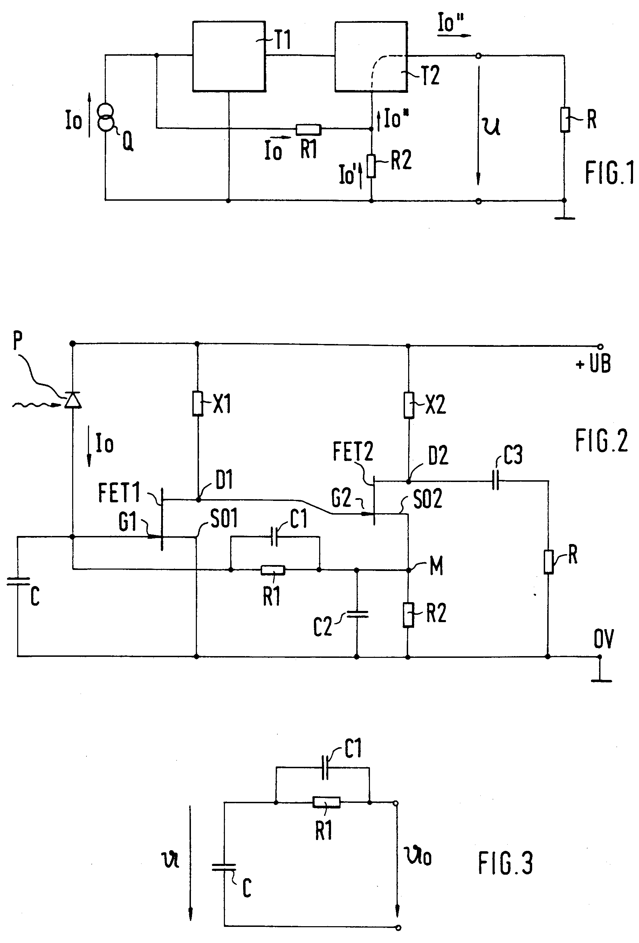

In der Figur 1 ist ein Blockschaltbild mit zwei hintereinander geschalteten Verstärkerstufen T1 und T2 gezeigt, die als Stromverstärker mit einer Strom-Strom-Gegenkopplung über einen Spannungsteiler aus Widerständen R1 und R2 aufgebaut sind. Der Widerstand R1 ist hierbei von der zweiten Stufe T2 auf den Eingang der ersten Stufe T1 zurückgeführt. Am Eingang der ersten Verstärkerstufe T1 befindet sich eine Stromquelle Q, die einen Strom Io als zuverstärkendes Signal abgibt. Am Ausgang der zweiten Verstärkerstufe T2 befindet sich ein Ausgangswiderstand R an dem die Ausgangsspannung U abnehmbar ist. Durch den Widerstand R1 fließt hierbei der Strom Io, durch den Widerstand R2 ein Strom

Io' = Io R1/R2

und am Ausgang der zweiten Stufe fließt ein Strom Io'' nach der Beziehung

Io'' = Io (1 + R1/R2),

wobei sich das Übertragungsmaß des Stromverstärkers von Io'' / Io ergibt.

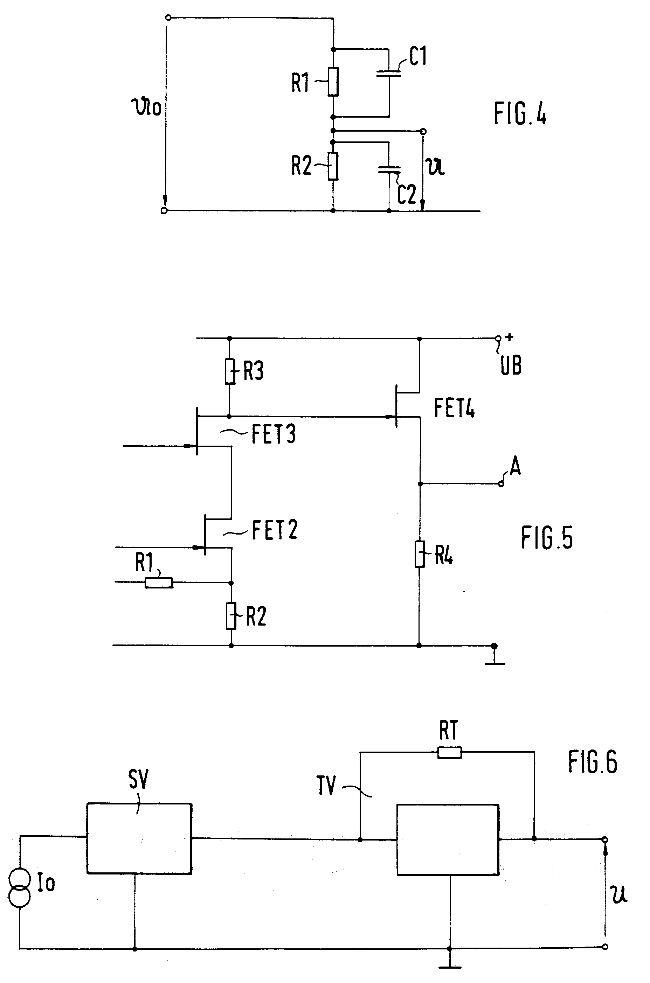

In der Figur 2 ist ein prinzipielles Ausführungsbeispiel der erfindungsgemäßen Schaltungsanordnung dargestellt, bei dem als Stromquelle eine PIN-Diode als Photodiode P zwischen dem Gate G1 einer ersten aus einem Feldeffekttransistor FET1 gebildeten Verstärkerstufe und dem positiven Pol der Betriebsspannung UB geschaltet ist. Diese Photodiode P liefert einen Strom Io als Eingangssignal des Stromverstärkers. Zwischen dem Gate G1 des Feldeffekttransistors FET1 und dem Nullpotential der Betriebsspannung UB befindet sich eine Kapazität C, die sich im wesentlichen aus den Schaltkapazitäten des Eingangsbereichs der Schaltungsanordnung einschließlich der Eigenkapazität der Photodiode P und des Feldeffekttransistors FET1 zusammensetzt. Daran angeschaltet befindet sich ein kapazitiver Übertragungsspannungsteiler bestehend aus einer ersten Parallelschaltung eines Widerstandes R1 und eines Kondensators C1 und einer zweiten Parallelschaltung aus einem Widerstand R2 und einem Kondensator C2. Der Übertragungsspannungsteiler ist einzeln in der Figur 4 dargestellt, wobei sich das Übertragungsmaß aus der Beziehung $\mathfrak{U}_o\mathfrak{U}$ herleiten läßt. In der Figur 3 ist ein Schleifenspannungsteiler, gebildet aus der Kapazität C und der Parallelschaltung aus R1 und C1 schematisch gezeigt, der für die Berechnung der Schleifenverstärkung maßgeblich ist und durch eine rechnerische Auftrennung des Gegenkopplungszweiges darstellbar ist.

Der Source-Anschluß SO1 des ersten Feldeffekttransistors FET1 (Figur 2) liegt direkt am Nullpotential der Betriebsspannung UB und der Drain-Anschluß D1 liegt einerseits über einem Widerstand X1 am positiven Pol der Betriebsspannung UB und andererseits direkt am Gate G2 eines zweiten Feldeffekttransistors FET2.

Der Source-Anschluß S2 des zweiten Feldeffekttransistors FET2 ist auf eine Mittenanzapfung M des kapazitiven Spannungsteilers geführt und der Drain-Anschluß D2 des zweiten Feldeffekttransistors FET2 liegt über einen Widerstand X2 am positiven Pol der Betriebsspannung UB und über einen Kondensator C3 an einem Ausgangswiderstand R; der Widerstandswert des Drain-Widerstandes X2 muß hierbei größer als der Wert des Ausgangswiderstandes R sein.

Um ein optimales Übertragungsverhalten der erfindungsgemäßen Schaltungsanordnung zu erhalten, ist der kapazitive Spannungsteiler so zu dimensionieren, daß die Zeitkonstanten der beiden Teile des kapazitiven Spannungsteilers gleich sind, d.h. es muß folgende Bedingung erfüllt sein:

R1·C1 = R2·C2.

Die komplexen Widerstände der beiden Teile des kapazitiven Spannungsteilers $\mathfrak{R}_1$ und $\mathfrak{R}_2$ ergeben sich wie folgt:

EP 0 509 272 A1

$$R1 = \frac{R1}{1 + j\omega \cdot R1 \cdot C1}$$

$$R2 = \frac{R2}{1 + j\omega \cdot R2 \cdot C2}$$

Die Stromverstärkung der Schaltungsanordnung ergibt sich somit zu

$$Vi = 1 + \frac{R1}{R2} \cdot \frac{1 + j\omega \cdot R2 \cdot C2}{1 + j\omega \cdot R1 \cdot C1}$$

und unter der Bedingung $R1 \cdot C1 = R2 \cdot C2$ zu

$Vi = 1 + C2/C1 = 1 + R1/R2$.

Die Schleifenverstärkung Vs der Schaltungsanordnung unter Berücksichtigung der Gegenkopplung über den kapazitiven Spannungsteiler errechnet sich nach folgender Formel:

$$Vs = \frac{S1 \cdot X1}{1 + \frac{R1}{1 + j\omega \cdot R1 \cdot C1} \cdot j\omega C}$$

wobei für tiefe Frequenzen

$Vst = S1 \cdot X1$

und für hohe Frequenzen

$$Vsh = \frac{S1 \cdot X1}{1 + \frac{C}{C1}}$$

gilt.

Unter der Annahme, daß die Steilheit S1 des Feldeffekttransistors FET1 50ms beträgt und beispielsweise folgende Dimensionierungen vorhanden sind:
X1 = 200 Ohm,
C = 1 pF,
C1 = 0,25 pF,
ergibt sich für tiefe Frequenzen eine Verstärkung von 20 dB und für hohe Frequenzen eine Verstärkung von 6 dB.

Aus diesen Ableitungen ist ersichtlich, daß das Verhältnis C/C1 die Schleifenverstärkung bei hohen Frequenzen bestimmt und somit durch optimale Auswahl des Kondensators C1 ein ausreichender Verstärkungswert der erfindungsgemäßen Schaltungsanordnung auch bei hohen Frequenzen gewährleistet werden kann.

Beim Ausführungsbeispiel nach der Figur 2 Kann als Ausgangswiderstand R beispielsweise ein Widerstandswert von 50 Ohm gewählt werden. Alternativ hierzu kann jedoch eine weitere Transistorstufe als Kaskodenschaltung gemäß Figur 5 angefügt werden. Anstatt des Lastwiderstandes X2 ist gemäß der Figur 5 eine Gate-Stufe bzw. eine Kaskodenschaltung mit einem Source-Folger vorhanden. Hierzu ist ein Feldeffekttransistor FET3 mit einem Lastwiderstand R3 vorhanden. Der Ausgang dieses Feldeffekttransistors FET3 ist auf den Gate-Anschluß des Ausgangsfeldeffekttransistors FET4 geführt, an dessen Sourcewider-

4

stand R4 das Ausgangssignal abnehmbar ist.

Ein weiteres Ausführungsbeispiel einer Ausgangsbeschaltung der erfindungsgemäßen Schaltungsanordnung ist in der Figur 6 dargestellt. Hier ist ein in bekannter Weise aufgebauter Transimpedanzverstärker TV an den Ausgang des hier als Block gemäß Figur 2 dargestellten Stromverstärkers SV geschaltet, wobei die Übertragungsfunktion des Transimpedanzverstärkers TV im wesentlichen von einem Rückkopplungswiderstand RT abhängt.

**Patentansprüche**

1. Schaltungsanordnung zur Verstärkung eines elektrischen Signals, das von einer Photodiode, abhängig von der Intensität des auf die Photodiode einfallenden Lichts, erzeugt wird, mit einem einen Rückkopplungswiderstand enthaltenden Gegenkopplungsnetzwerk ,
   **dadurch gekennzeichnet**, daß
   die Schaltungsanordnung als Stromverstärker mit einer Strom-Strom-Gegenkopplung ausgebildet ist, daß das Gegenkopplungsnetzwerk (C,C1,R1,C2,R2) zur Kompensation des vom Rückkopplungswiderstand (R1) und von einem Kondensator (C1) des Gegenkopplungsnetzwerkes (C,C1,R1,C2, R2) beeinflußten Frequenzgangs der Schaltungsanordnung aus zwei kapazitiven Spannungsteilern gebildet ist, wobei ein Übertragungsspannungsteiler (C1,R1,C2,R2) im Gegenkopplungszweig des Stromverstärkers und ein Schleifenspannungsteiler (C,C1,R1) am Eingang des Stromverstärkers vorhanden sind und daß der Wert des Kondensators (C1) des Übertragungsspannungsteilers so gewählt ist, daß ein Optimum an Schleifenverstärkung auch bei der höchsten geforderten Grenzfrequenz der Schaltungsanordnung gewährleistet ist.

2. Schaltungsanordnung nach Anspruch 1
   **dadurch gekennzeichnet**, daß
   die Schaltungsanordnung ein zweistufiger Transistorverstärker, bestehend aus einer Emitter(Source)- und Kollektor(Drain)stufe, ist, und daß der Emitter-/Source-Anschluß (SO2) des zweiten Transistors (FET2) als niederohmiger Schaltungspunkt an den Mittenanschluß (M) des kapazitiven Spannungsteilers (C,C1,R1,C2,R2) angeschaltet ist, wobei die Zeitkonstanten der beiden Teile (R1,C1 / R2,C2) des kapazitiven Spannungsteilers annähernd gleich bemessen sind.

3. Schaltungsanordnung nach Anspruch 2
   **dadurch gekennzeichnet**, daß
   der Transistorverstärker aus zwei Feldeffekttransistoren (FET1,FET2) besteht und wie folgt aufgebaut ist:
   - eine PIN-Diode als Photodiode (P) befindet sich zwischen dem Gate (G1) des ersten Transistors (FET1) und dem positiven Pol der Betriebsspannung (UB),
   - der Drain-Anschluß (D1) des ersten Transistors (FET1) liegt über einen Widerstand (X1) am positiven Pol der Betriebsspannung (UB) und der Source-Anschluß (SO1) liegt direkt am Nullpotential der Betriebsspannung (UB),
   - zwischen dem Gate (G1) des ersten Transistors (FET1) und dem Nullpotential der Betriebsspannung (UB) liegt eine Kapazität (C), in deren schaltungstechnisch wirksame Größe die Schaltkapazitäten des Eingangsbereichs der Schaltungsanordnung einfließen , sowie der Übertragungsspannungsteiler (R1,C1,R2,C2),
   - der Gate-Anschluß (G2) des zweiten Transistors (FET2) ist mit dem Drain-Anschluß (D1) des ersten Transistors (FET1) verbunden,
   - der Source-Anschluß (SO2) des zweiten Transistors (FET2) liegt am Mittelanschluß des kapazitiven Spannungsteilers (R1,C1,R2,C2) und der Drain-Anschluß (D2) ist über einen Widerstand (X2) an den positiven Pol der Betriebsspannung (UB) sowie über einen Kondensator (C3) an einen Widerstand (R) angeschaltet, an dem das Ausgangssignal abnehmbar ist.

4. Schaltungsanordnung nach Anspruch 3
   **dadurch gekennzeichnet**, daß
   der Widerstand (R) am Ausgang der Schaltungsanordnung den Wert 50 Ohm aufweist.

5. Schaltungsanordnung nach Anspruch 3
   **dadurch gekennzeichnet**, daß
   der Widerstand (R) am Ausgang der Schaltungsanordnung eine Gate-Drain-Stufe aus weiteren Feldeffekttransistoren (FET3,FET4) ist.

6.  Schaltungsanordnung nach Anspruch 3
    **dadurch gekennzeichnet**, daß
    der Widerstand (R) am Ausgang der Schaltungsanordnung eine Transimpedanzverstärkerschaltung ist.

FIG.1

FIG.2

FIG.3

FIG.4

FIG.5

FIG.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 630 598 (THOMSON-CSF) | 1 | H03F3/08 |
| A | * Seite 2, Zeile 27 - Zeile 30 * | 2,3 | H03F1/48 |
| | * Seite 6, Zeile 21 - Seite 9, Zeile 8 * | | |
| | * Abbildungen 4,5 * | | |
| | --- | | |
| Y | ELECTRONIC LETTERS | 1 | |
| | Bd. 24, Nr. 16, 4. August 1988, STEVENAGE,G.B. | | |
| | Seiten 1024 - 1025; | | |
| | R.F.M.VAN DEN BRINK: 'Optical Receiver with | | |
| | Third-Order Capacitive Current-Current Feedback' | | |
| A | * das ganze Dokument * | 2,3 | |
| | --- | | |
| Y | PATENT ABSTRACTS OF JAPAN | 1 | |
| | vol. 10, no. 201 (E-419)(2257) 15. Juli 1986 | | |
| | & JP-A-61 043 004 ( FUJITSU LTD ) 1. März 1986 | | |
| A | | 2,3 | |
| | * Zusammenfassung * | | |
| | --- | | |
| A | US-A-4 075 576 (RICHARD C. EOEN) | 1-3 | |
| | * Zusammenfassung; Abbildung 1 * | | |
| | ----- | | |

RECHERCHIERTE
SACHGEBIETE (Int. Cl.5)

H03F

Der vorliegende Recherchenbericht wurde für alle Patentansprüche erstellt

| Recherchenort | Abschlußdatum der Recherche | Prüfer |
|---|---|---|
| DEN HAAG | 30 JULI 1992 | WALDORFF U. |